# Europäisches Patentamt
## European Patent Office
## Office européen des brevets

(11) Veröffentlichungsnummer: **0 201 700**
**B1**

(12) **EUROPÄISCHE PATENTSCHRIFT**

(45) Veröffentlichungstag der Patentschrift:
07.02.90

(51) Int. Cl.⁴: **H02M 1/06**, H03K 17/60

(21) Anmeldenummer: **86104210.9**

(22) Anmeldetag: **26.03.86**

(54) Ansteuerung für ein- und ausschaltbare Leistungshalbleiterelemente.

(30) Priorität: **12.04.85 DE 3513170**

(43) Veröffentlichungstag der Anmeldung:
**20.11.86 Patentblatt 86/47**

(45) Bekanntmachung des Hinweises auf die Patenterteilung:
**07.02.90 Patentblatt 90/6**

(84) Benannte Vertragsstaaten:
**AT CH DE GB LI**

(56) Entgegenhaltungen:
EP-A- 0 154 062
DE-A- 2 913 974

(73) Patentinhaber: **Siemens Aktiengesellschaft,
Wittelsbacherplatz 2, D-8000 München 2(DE)**

(72) Erfinder: **Marquardt, Rainer, Dr., Eskilstunastrasse 29,
D-8520 Erlangen(DE)**

## Beschreibung

Beschreibung für die Vertragsstaaten: AT, CH, LI

Die Erfindung betrifft ein Verfahren zum Ansteuern ein- und ausschaltbarer Leistungshalbleiterbauelemente, wobei die Steuerleistung mittels einer Impulsfolge mit einem Transformator übertragen und anschließend die Impulsfolge gleichgerichtet wird und eine Vorrichtung zur Durchführung des Verfahrens für einen ausschaltbaren Thyristor, mit einem Transformator, dessen Primärwicklung über einen ersten steuerbaren Schalter mit einer Impulsfolge beaufschlagbar ist und dessen beiden Sekundärwicklungen Gleichrichter nachgeschaltet sind, wobei eine Sekundärwicklung eine Hilfsspannungsquelle speist, die über einen zweiten steuerbaren Schalter an die Gate-Katodenstrecke des Thyristors schaltbar ist.

Ein solches Verfahren und eine solche Vorrichtung zur Durchführung des Verfahrens sind aus der JP-A 57-12 62 70 (A) bekannt.

Die Steuerung von in Geräten der Leistungselektronik eingesetzten Leistungshalbleiterbauelementen erfordert im allgemeinen eine Potentialtrennung zur Isolation des Steuerteils vom Leistungsteil. Bei konventionellen Thyristoren als Leistungshalbleiterbauelemente erfolgt die Potentialtrennung mittels eines Impulstransformators, der die Steuerströme direkt in die Gate-Katodenstrecke, die Steuerstrecke des Thyristors einspeist.

Bei Leistungstransistoren und steuerstromseitig abschaltbaren Thyristoren, den sogenannten GTO-Thyristoren ist der Aufwand für die potentialgetrennte Steuerung stark angestiegen. Benötigt werden im allgemeinen impulsförmige Steuerströme beider Polaritäten, z.B. ein positiver Impuls für das Einschalten und ein negativer Impuls für das Abschalten des Leistungshalbleiterbauelements. Außerdem müssen während der Einschalt- bzw. Abschaltzeit des Leistungshalbleiterbauelements die Steuerströme bzw. -spannungen vorhanden sein, z.B. ein positiver Steuerstrom während der Einschaltzeit und eine negative Steuerspannung während der Abschaltzeit.

Bei der bekannten Vorrichtung ist eine der Sekundärwicklungen über Gleichrichter direkt mit der Gate-Katodenstrecke des GTO-Thyristors verbunden. Über diese Sekundärwicklung wird der positive Steuerstrom während der Einschaltzeit eingespeist. Über die zweite Sekundärwicklung wird ein Kondensator als Hilfsspannungsquelle aufgeladen, der über einen Transistor auf die Primärwicklung eines zweiten Transformators entladbar ist, dessen Sekundärwicklung zur Einspeisung des negativen Ausschaltstromes über Dioden ebenfalls mit der Gate-Katodenstrecke des Thyristors verbunden ist. Bei dieser Vorrichtung werden mehrere Impulstransformatoren benötigt, was den Aufwand erhöht. Außerdem ist die Stromsteilheit der Steuerströme durch die Streuinduktivitäten der Impulstransformatoren begrenzt. Dies führt insbesondere bei hohen Anforderungen an die Isolationsspannung und bei der Steuerung leistungsstarker Halbleiterbauelemente zu Schwierigkeiten.

Im Handel erhältlich ist ein Steuerteil für die potentialgetrennte Steuerung von Leistungstransistoren, bei dem die Steuerinformation, d.h., der Befehl zum Ein- oder Abschalten des Leistungstransistors potentialgetrennt optoelektronisch übertragen wird. Mit der Steuerinformation wird ein Impulsverstärker angesteuert, der zwei Hilfsspannungsquellen abwechselnd mit entgegengesetzter Polarität an die Basis-Emitterstrecke des Leistungstransistors anschaltet. Dabei sind die Hilfsspannungsquellen, die auch die Energie für den Impulsverstärker liefern, von der Steuerung ebenfalls potentialgetrennt. Auch diese Schaltung ist sehr aufwendig.

Es besteht die Aufgabe, ein Verfahren der eingangs genannten Art so auszugestalten, daß der Aufwand zur potentialgetrennten Übertragung sowohl der Steuerleistung als auch der Steuerinformation vermindert wird.

Erfindungsgemäß wird diese Aufgabe dadurch gelöst, daß die Steuerinformation der Impulsfolge durch Modulation aufgeprägt wird und daß die Impulsfolge nach der potentialgetrennten Übertragung demoduliert wird.

Bei dem erfindungsgemäßen Verfahren wird sowohl die Steuerleistung als auch die Steuerinformation mit der gleichen Impulsfolge übertragen. Es ist daher nur eine Isolationsstrecke zwischen Steuer- und Leistungsteil erforderlich. Der benötigte Impulstransformator kann außerdem auf hohe Isolationsspannung und kleines Volumen ausgelegt werden, da eine große Streuinduktivität zulässig ist.

Vorteilhaft ist es, die Impulsfolge eine Pulsdauermodulation oder einer Pulsfrequenzmodulation zu unterziehen. Als besonders vorteilhaft hat sich die Impulsdauermodulation erwiesen, da sich bei ihr ein einfacher Demodulator mit einem Tiefpaß mit nachfolgendem Komparator realisieren läßt. Zusätzlich hat man die Möglichkeit, die Lastabhängigkeit der Steuerspannungen, die durch eventuelle unterschiedliche Belastung während des Ein- bzw. Ausschaltzustandes auftritt durch ein passend gewähltes Puls-Pausenverhältnis zu kompensieren. Außerdem kann bei der Pulsdauermodulation dem Ausfall der Impulsfolge ein sicherer Schaltzustand dazugeordnet werden. Wird z.B. das kleinere Puls-Pausenverhältnis dem Ausschaltzustand zugeordnet, so läßt sich bei Ausfall der Impulsfolge ein automatisches Ausschalten des angeschlossenen Halbleiterschalters realisieren.

Bei einer eingangs genannten vorteilhaften Vorrichtung zur Durchführung des Verfahrens ist der erste Schalter von einer Modulationsstufe aussteuerbar und auch die andere Sekundärwicklung speist eine Hilfsspannungsquelle, die über einen dritten steuerbaren Schalter an die Gate-Katodenstrecke des Thyristors schaltbar ist und eine Sekundärwicklung ist mit einer Demodulationsstufe verbunden, deren Ausgangssignal abwechselnd den zweiten oder dritten Schalter betätigt.

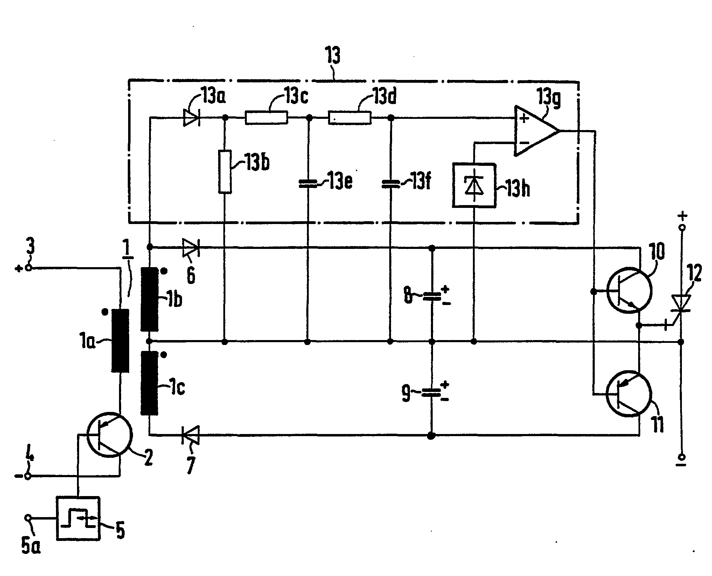

Im folgenden wird das erfindungsgemäße Verfahren beispielshaft anhand der Figur näher erläutert.

Die Figur zeigt das Schaltbild eines Steuerteiles, das nach dem erfindungsgemäßen Verfahren betrieben wird. Die Primärwicklung 1a eines Impulsübertragers 1 ist über einen Transistor 2 mit den
Klemmen 3 und 4 einer Gleichspannungsquelle verbunden. Die Basis des Transistors 2 wird von einer
Modulationsstufe 5 angesteuert, an deren Steuereingang 5a Steuerimpulse anstehen. Als Modulationsstufe kann beispielsweise ein RC-Oszillator eingesetzt sein, der eine pulsdauermodulierte Impulsfolge mit einer Pulsfrequenz von ca. 1MHz erzeugt.
Bei der Pulsdauermodulation werden die Rückflanken der einzelnen Impulse so moduliert, daß dem Zustand Eins der Zündsignale, was dem Befehl
"Thyristor Ein" entspricht eine kleine Impulspause
und dem Zustand Null, was dem Befehl "Thyristor
Aus" entspricht, eine größere Impulspause zugeordnet ist.

Die beiden Sekundärwicklungen 1b und 1c des Impulsübertragers 1 sind über jeweils eine Diode 6
bzw. 7 mit Kondensatoren 8 bzw. 9 verbunden, die
als Hilfsspannungsquellen dienen. Über Transistoren 10 bzw. 11 in Gegentaktschaltung werden die
Kondensatoren 8 bzw. 9 an die Gate-Katodenstrecke des Thyristors 12 angelegt, wobei die Katode des Thyristors 12 mit dem Verbindungspunkt der
beiden Sekundärwicklungen 1b und 1c verbunden
ist, der das Potential Null besitzt.

Die Abgriffe der Sekundärwicklung 1b sind außerdem an eine Demodulationsstufe 13 geführt, die
im Ausführungsbeispiel mit einem Tiefpaß und nachgeschaltetem Komparator realisiert ist. Dem einen
Abgriff der Sekundärwicklung 1b ist eine Diode 13a
als Gleichrichter und ein Überbrückungswiderstand
13b nachgeschaltet. Die Diode 13a ist mit dem Tiefpaß verbunden, zu dem die Widerstände 13c und 13d
und die Kondensatoren 13e und 13f verschaltet
sind. Der Ausgang des Tiefpasses liegt am nicht invertierenden Eingang eines Operationsverstärkers 13g, bei dessen invertierender Eingang mit einer Schwellwertsspannungsquelle 13h verbunden
ist. Der Ausgang des Operationsverstärkers 13g
liegt an den Steuereingängen der Transistoren 10
und 11, die den Impulsverstärker bilden.

Die vom Transformator 1 übertragene, pulsdauermodulierte Impulsfolge wird von den Gleichrichtern
6 und 7 gleichgerichtet und läd die Kondensatoren 8
und 9 auf. Die Impulsfolge dient damit zur Übertragung der Steuerleistung. Die mit der Pulsdauermodulation aufgeprägte Steuerinformation wird in der
Demodulationsstufe zurückgewonnen. Am Ausgang
des Tiefpaßes steht eine Gleichspannung an, deren
Größe dem Puls-Pausenverhältnis der Impulsfolge
proportional ist. Die Schwellwertspannung ist so gewählt, daß sie zwischen dem Maximalwert der Ausgangsspannung des Tiefpaßes, der den Befehl
"Thyristor ein" entspricht und den Minimalwert der
Ausgangsspannung liegt, der den Befehl "Thyrister
aus" zugeordnet ist. Am Ausgang des Komparators
13g steht damit ein Signal an, das zum Einschalten
des Thyristors 12 positiv und zum Ausschalten des
Thyristors 12 negativ ist. Mit diesem Steuersignal
werden die Transistoren 10 und 11 abwechselnd ausgesteuert und damit der GTO-Thyristor 12 gezündet
bzw. gelöscht.

Beschreibung für die Vertragsstaaten: DE, GB

Die Erfindung betrifft eine Vorrichtung zum Ansteuern eines ein- und ausschaltbaren Leistungshalbleiterbauelementes mit einem Transformator,
dessen Primärwicklung über einen ersten steuerbaren Schalter mit einer Impulsfolge beaufschlagbar
ist und dessen beiden Sekundärwicklungen Gleichrichter nachgeschaltet sind, wobei eine Sekundärwicklung eine Hilfsspannungsquelle speist, die über
einen zweiten steuerbaren Schalter an die Gate-
Kathodenstrecke des Thyristors schaltbar ist.

Eine solche Vorrichtung ist aus der JP-A 126 270
(a) bekannt.

Die Steuerung von in Geräten der Leistungselektronik eingesetzten Leistungshalbleiterbauelementen erfordert im allgemeinen eine Potentialtrennung
zur Isolation des Steuerteils vom Leistungsteil. Bei
konventionellen Thyristoren als Leistungshalbleiterbauelemente erfolgt die Potentialtrennung mittels eines Impulstransformators, der die Steuerströme direkt in die Gate-Kathodenstrecke, die Steuerstrecke des Thyristors einspeist.

Bei Leistungstransistoren und steuerstromseitig
abschaltbaren Thyristoren, den sogenannten GTO-
Thyristoren ist der Aufwand für die potentialgetrennte Steuerung stark angestiegen. Benötigt werden im allgemeinen impulsförmige Steuerströme beider Polaritäten, z.B. ein positiver Impuls für das
Einschalten und ein negativer Impuls für das Abschalten des Leistungshalbleiterbauelements. Außerdem müssen während der Einschalt- bzw. Abschaltzeit des Leistungshalbleiterbauelements die
Steuerströme bzw. -spannungen vorhanden sein,
z.B. ein positiver Steuerstrom während der Einschaltzeit und eine negative Steuerspannung während der Abschaltzeit.

Bei der aus der JP-A 57 126 270 (A) bekannten
Vorrichtung ist eine der Sekundärwicklungen über
Gleichrichter direkt mit der Gate-Kathodenstrecke
des GTO-Thyristors verbunden. Über diese Sekundärwicklung wird der positive Steuerstrom während
der Einschaltzeit eingespeist. Über die zweite Sekundärwicklung wird ein Kondensator als Hilfsspannungsquelle aufgeladen, der über einen Transistor
auf die Primärwicklung eines zweiten Transformators entladbar ist, dessen Sekundärwicklung zur
Einspeisung des negativen Ausschaltstromes über
Dioden ebenfalls mit der Gate-Kathodenstrecke
des Thyristors verbunden ist. Bei dieser Vorrichtung werden mehrere Impulstransformatoren benötigt, was den Aufwand erhöht. Außerdem ist die
Stromsteilheit der Steuerströme durch die Streuinduktivitäten der Impulstransformatoren begrenzt.
Dies führt insbesondere bei hohen Anforderungen
an die Isolationsspannung und bei der Steuerung leistungsstarker Halbleiterbauelemente zu Schwierigkeiten.

Im Handel erhältlich ist ein Steuerteil für die potentialgetrennte Steuerung von Leistungstransistoren, bei dem die Steuerinformation, d.h. der Befehl
zum Ein- oder Abschalten des Leistungstransistors
potentialgetrennt optoelektronisch übertragen wird.
Mit der Steuerinformation wird ein Impulsverstärker angesteuert, der zwei Hilfsspannungsquellen abwechselnd mit entgegengesetzter Polarität an die Basis-Emitterstrecke des Leistungstransistors anschaltet. Dabei sind die Hilfsspannungsquellen, die auch die Energie für den Impulsverstärker liefern, von der Steuerung ebenfalls potentialgetrennt. Auch diese Schaltung ist sehr aufwendig.

Aus der früheren europäischen Patentanmeldung EP-A 0 154 062 ist eine Leistungs-Steuervorrichtung für einen Leistungsschalter, beispielsweise einen MOS-FET, bekannt, bei der die Steuerinformation der Impulsfolge für den Leistungsschalter durch Modulation einem hochfrequenten Taktsignal aufgeprägt wird. Dieses modulierte Signal wird nach der potentialgetrennten Übertragung einer Demodulationsstufe zugeführt. Außerdem wird aus diesem modulierten Signal mittels einer Gleichrichteranordnung eine Hilfsspannung für die Demodulationsstufe erzeugt.

Bei dem bekannten Verfahren wird sowohl die Steuerleistung als auch die Steuerinformation mit der gleichen Impulsfolge übertragen. Es ist daher nur eine Isolationsstrecke zwischen Steuer- und Leistungsteil erforderlich. Der benötigte Impulstransformator kann außerdem auf hohe Isolationsspannung und kleines Volumen ausgelegt werden, da eine große Streuinduktivität zulässig ist.

Es besteht die Aufgabe, eine Vorrichtung der eingangs genannten Art so auszugestalten, daß der Aufwand zur potentialgetrennten Übertragung sowohl der Steuerleistung als auch der Steuerinformation vermindert wird.

Erfindungsgemäß wird diese Aufgabe dadurch gelöst, daß der erste Schalter von einer Modulationsstufe aussteuerbar ist, daß auch die andere Sekundärwicklung eine Hilfsspannungsquelle speist, die über einen dritten steuerbaren Schalter an die Gate-Kathodenstrecke des Thyristors schaltbar ist, und daß eine Sekundärwicklung mit einer Demodulationsstufe verbunden ist, deren Ausgangssignal abwechselnd den zweiten oder dritten Schalter betätigt.

Bei der erfindungsgemäßen Vorrichtung ist bei der Verwendung einer Impulsdauermodulation die Demodulationsstufe durch ein Tiefpaß mit nachfolgendem Komparator realisierbar. Auch der Aufbau der Hilfsspannungsquelle ist sehr einfach aufgebaut, wodurch die Vorrichtung zum Ansteuern eines ein- und ausschaltbaren Leistungshalbleiterbauelementes besonders einfach aufgebaut ist. Somit wird der Aufwand zur potentialgetrennten Übertragung sowohl der Steuerleistung als auch der Steuerinformation vermindert.

Im folgenden wird das erfindungsgemäße Verfahren beispielhaft anhand der Figur näher erläutert.

Die Figur zeigt das Schaltbild eines Steuerteiles, das nach dem erfindungsgemäßen Verfahren betrieben wird. Die Primärwicklung la eines Impulsübertragers 1 ist über einen Transistor 2 mit den Klemmen 3 und 4 einer Gleichspannungsquelle verbunden. Die Basis des Transistors 2 wird von einer Modulationsstufe 5 angesteuert, an deren Steuereingang 5a Steuerimpulse anstehen. Als Modulationsstufe kann beispielsweise ein RC-Oszillator eingesetzt sein, der eine pulsdauermodulierte Impulsfolge mit einer Pulsfrequenz von ca. 1MHz erzeugt.

Bei der Pulsdauermodulation werden die Rückflanken der einzelnen Impulse so moduliert, daß dem Zustand Eins der Zündsignale, was dem Befehl "Thyristor Ein" entspricht eine kleine Impulspause und dem Zustand Null, was dem Befehl "Thyristor Aus" entspricht, eine größere Impulspause zugeordnet ist.

Die beiden Sekundärwicklungen 1b und 1c des Impulsübertragers 1 sind über jeweils eine Diode 6 bzw. 7 mit Kondensatoren 8 bzw. 9 verbunden, die als Hilfsspannungsquellen dienen. Über Transistoren 10 bzw. 11 in Gegentaktschaltung werden die Kondensatoren 8 bzw. 9 an die Gate-Katodenstrecke des Thyristors 12 angelegt, wobei die Katode des Thyristors 12 mit dem Verbindungspunkt der beiden Sekundärwicklungen 1b und 1c verbunden ist, der das Potential Null besitzt.

Die Abgriffe der Sekundärwicklung 1b sind außerdem an eine Demodulationsstufe 13 geführt, die im Ausführungsbeispiel mit einem Tiefpaß und nachgeschaltetem Komparator realisiert ist. Dem einen Abgriff der Sekundärwicklung 1b ist eine Diode 13a als Gleichrichter und ein Überbrückungswiderstand 13b nachgeschaltet. Die Diode 13a ist mit dem Tiefpaß verbunden, zu dem die Widerstände 13c und 13d und die Kondensatoren 13e und 13f verschaltet sind. Der Ausgang des Tiefpasses liegt am nicht invertierenden Eingang eines Operationsverstärkers 13g, bei dessen invertierender Eingang mit einer Schwellwertsspannungsquelle 13h verbunden ist. Der Ausgang des Operationsverstärkers 13g liegt an den Steuereingängen der Transistoren 10 und 11, die den Impulsverstärker bilden.

Die vom Transformator 1 übertragene, pulsdauermodulierte Impulsfolge wird von den Gleichrichtern 6 und 7 gleichgerichtet und läd die Kondensatoren 8 und 9 auf. Die Impulsfolge dient damit zur Übertragung der Steuerleistung. Die mit der Pulsdauermodulation aufgeprägte Steuerinformation wird in der Demodulationsstufe zurückgewonnen. Am Ausgang des Tiefpaßes steht eine Gleichspannung an, deren Größe dem Puls-Pausenverhältnis der Impulsfolge proportional ist. Die Schwellwertspannung ist so gewählt, daß sie zwischen dem Maximalwert der Ausgangsspannung des Tiefpaßes, der den Befehl "Thyristor ein" entspricht und den Minimalwert der Ausgangsspannung liegt, der den Befehl "Thyrister aus" zugeordnet ist. Am Ausgang des Komparators 13g steht damit ein Signal an, das zum Einschalten des Thyristors 12 positiv und zum Ausschalten des Thyristors 12 negativ ist. Mit diesem Steuersignal werden die Transistoren 10 und 11 abwechselnd ausgesteuert und damit der GTO-Thyristor 12 gezündet bzw. gelöscht.

**Patentansprüche für die Vertragsstaaten: AT, CH, LI**

1) Verfahren zum Ansteuern ein- und ausschaltbarer Leistungshalbleiterbauelemente (12), wobei die Steuerleistung mittels einer Impulsfolge mit einem Transformator (1) übertragen und anschließend die Impulsfolge gleichgerichtet wird, **dadurch gekennzeichnet,** daß die Steuerinformation der Impulsfolge durch Modulation aufgeprägt wird und daß die Impulsfolge nach der potentialgetrennten Übertragung demoduliert wird.

2) Verfahren nach Anspruch 1,
**dadurch gekennzeichnet,** daß die Impulsfolge einer Pulsdauermodulation unterzogen wird.

3) Verfahren nach Anspruch 1,
**dadurch gekennzeichnet,** daß die Impulsfolge einer Pulsfrequenzmodulation unterzogen wird.

4) Vorrichtung zur Durchführung des Verfahrens nach einem der Ansprüche 1 bis 3 für einen ausschaltbaren Thyristor (12), mit einem Transformator (1), dessen Primärwicklung (1a) über einen ersten steuerbaren Schalter (2) mit einer Impulsfolge beaufschlagbar ist und dessen beiden Sekundärwicklungen Gleichrichter nachgeschaltet sind, wobei eine Sekundärwicklung eine Hilfsspannungsquelle (9) speist, die über einen zweiten steuerbaren Schalter (11) an die Gate-Katodenstrecke des Thyristors schaltbar ist,
**dadurch gekennzeichnet,** daß der erste Schalter (2) von einer Modulationsstufe (5) ansteuerbar ist, daß auch die andere Sekundärwicklung (1b) eine Hilfsspannungsquelle (8) speist, die über einen dritten steuerbaren Schalter (10) an die Gate-Katodenstrecke des Thyristors (12) schaltbar ist und daß eine Sekundärwicklung (1b) mit einer Demodulationsstufe (13) verbunden ist, deren Ausgangssignal abwechselnd den zweiten oder dritten Schalter (10, 11) betätigt.

**Patentansprüche für die Vertragsstaaten: DE, GB**

1. Vorrichtung zum Ansteuern eines ein- und ausschaltbaren Thyristors (12) mit einem Transformator (1), dessen Primärwicklung (1a) über einen ersten steuerbaren Schalter mit einer Impulsfolge beaufschlagbar ist und dessen beiden Sekundärwicklungen Gleichrichter nachgeschaltet sind, wobei eine Sekundärwicklung eine Hilfsspannungsquelle speist, die über einen zweiten steuerbaren Schalter an die Gate-Kathodenstrecke des Thyristors schaltbar ist, dadurch gekennzeichnet, daß der erste Schalter (2) von einer Modulationsstufe (5) ansteuerbar ist, daß auch die andere Sekundärwicklung (1b) eine Hilfsspannungsquelle (8) speist, die über einen dritten steuerbaren Schalter (10) an die Gate-Kathodenstrecke des Thyristors (12) schaltbar ist, und daß eine Sekundärwicklung (1b) mit einer Demodulationsstufe (13) verbunden ist, deren Ausgangssignal abwechselnd den zweiten oder dritten Schalter (10, 11) betätigt.

**Claims for the contracting states: AT, CH, LI**

1. Method for controlling power semiconductor components (12), which components can be switched on and off, wherein the control power is transferred, by means of a pulse train, through a transformer (1) and subsequently the pulse train is rectified, characterised in that the control information is impressed on the pulse train by modulation and that the pulse train is demodulated after the electrically isolating transfer.

2. Method according to claim 1, characterised in that the pulse train is subjected to pulse-duration modulation.

3. Method according to claim 1, characterised in that the pulse train is subjected to pulse-frequency modulation.

4. Device for carrying out the method according to one of claims 1 to 3 for a thyristor (12), which thyristor can be switched off, including a transformer (1), whose primary winding (1a) can receive a pulse train by way of a first controllable switch (2) and which has rectifiers connected to both of its secondary windings, wherein one secondary winding supplies an auxiliary power source (9) can be switched to the gate-cathode thyristor by way of a second controllable switch (11), characterised in that the first switch (2) is controllable by a modulation stage (5), in that the other secondary winding (1b) also supplies an auxiliary power source (8) which can be switched to the gate-cathode path of the thyristor (12) by way of a third controllable switch (10), and in that a secondary winding (1b) is connected to a demodulation stage (13), the output signal of which activates the second and third switches (10, 11) alternately.

**Claims for the contracting states: DE, GB**

1. Device for controlling a thyristor (12), which thyristor can be switched on and off, including a transformer (1), whose primary winding (1a) can receive a pulse train by way of a first controllable switch and which has rectifiers connected to both of its secondary windings, wherein one secondary winding supplies an auxiliary power source which can be switched to the gate-cathode path of the thyristor by way of a second controllable switch, characterised in that the first switch (2) is controllable by a modulation stage (5), in that the other secondary winding (1b) also supplies an auxiliary power source (8) which can be switched to the gate-cathode path of the thyristor (12) by way of a third controllable switch (10), and in that a secondary winding (1b) is connected to a demodulation stage (13), the output signal of which activates the second and third switches (10, 11) alternately.

**Revendications pour les états contractants: AT, CH, LI**

1. Procédé pour attaquer des composants de puissance à semiconducteurs (12), pouvant être placés à l'état conducteur et à l'état bloqué, et selon lequel la puissance d'attaque est transmise au moyen d'une suite d'impulsions, à l'aide d'un transformateur (1), et la suite d'impulsions est ensuite redressée, caractérisé par le fait que l'information d'attaque de la suite d'impulsions est appliquée au moyen d'une modulation et que la suite d'impulsions est démodulée après la transmission effectuée avec séparation de potentiel.

2. Procédé suivant la revendication 1, caractérisé par le fait que la suite d'impulsions est soumise à une modulation d'impulsions en durée.

3. Procédé suivant la revendication 1, caractérisé par le fait que la suite d'impulsions est soumise à une modulation de la fréquence des impulsions.

4. Dispositif pour la mise en œuvre du procédé suivant l'une des revendications 1 à 3, pour un thyristor (12) pouvant être placé à l'état bloqué, comportant un transformateur (1), dont l'enroulement primaire (1a) peut être chargé par une suite d'impulsions par l'intermédiaire d'un premier interrupteur commandable (2) et en aval avec les deux enroulements secondaires duquel sont branchés des redresseurs, un enroulement secondaire alimentant une source de tension auxiliaire (9), qui peut être raccordée à la voie grille-cathode du thyristor par l'intermédiaire d'un second interrupteur commandable (11), caractérisé par le fait que le premier interrupteur (2) peut être commandé par un étage de modulation (5), que l'autre enroulement secondaire (1b) alimente également une source de tension auxiliaire (8), qui peut être raccordée à la voie grille-cathode du thyristor (12) par l'intermédiaire d'un troisième interrupteur commandable (10) et qu'un enroulement secondaire (1b) est relié à un étage de démodulation (13), dont le signal de sortie actionne alternativement le second ou le troisième interrupteur (10, 11).

**Revendications pour les états contractants: DE, GB**

Dispositif pour attaquer un thyristor (12) pouvant être placé à l'état conducteur et à l'état bloqué, comportant un transformateur (1), dont l'enroulement primaire (1a) peut être chargé par une suite d'impulsions par l'intermédiaire d'un premier interrupteur commandable (2) et en aval avec les deux enroulements secondaires duquel sont branchés des redresseurs, un enroulement secondaire alimentant une source de tension auxiliaire, qui peut être raccordée à la voie grille-cathode du thyristor par l'intermédiaire d'un second interrupteur commandable, caractérisé par le fait que le premier interrupteur (2) peut être commandé par un étage de modulation (5), que l'autre enroulement secondaire (1b) alimente également une source de tension auxiliaire (8), qui peut être raccordée à la voie grille-cathode du thyristor (12) par l'intermédiaire d'un troisième interrupteur commandable (10) et qu'un enroulement secondaire (1b) est relié à un étage de démodulation (13), dont le signal de sortie actionne alternativement le second ou le troisième interrupteur (10).